Europäisches Patentamt

(19) European Patent Office

Office européen des brevets

(11) Publication number: **0 008 002**
**A1**

## (12) EUROPEAN PATENT APPLICATION

(21) Application number: **79102334.4**

(22) Date of filing: **09.07.79**

(51) Int. Cl.³: **G 01 R 31/28, G 01 R 31/02**

(30) Priority: **31.07.78 US 929480**

(43) Date of publication of application: **20.02.80**
**Bulletin 80/4**

(84) Designated Contracting States: **DE FR GB**

(71) Applicant: **International Business Machines Corporation, Armonk, N.Y. 10504 (US)**

(72) Inventor: **McMahon, Jr., Maurice Thomas, 40 Brentwood Drive, Poughkeepsie, New York 12603 (US)**

(74) Representative: **Richards, John Peter, IBM UNITED KINGDOM PATENT OPERATIONS Hursley Park, Winchester Hants SO21 2JN (GB)**

(54) **Electronic circuit package and method of testing such package.**

(57) This invention relates to electronic circuit package and method of testing such package, and deals with the testing of a network of electrical interconnections between chips (20) mounted on an insulating substrate (10) of a circuit module and between the chips and the input and output pins of the module. Each of the mounted chips (20) contains masking circuits which can be activated to prevent signals from the outputs of logic circuits on the chip from being transmitted off the chip and into the interconnection network (11). Also each of the chips (20) contains emitter follower circuits (40) that logically connect all the chip input terminals to a common output terminal (23) of the chip. In testing, the mask circuits are activated. Then potential levels are selectively applied to a plurality of test points in the interconnection network and differences in potential level between these test points and/or between the points and one or more of the common terminals are determined.

1

ELECTRONIC CIRCUIT PACKAGE AND METHOD
OF TESTING SUCH PACKAGE

The present invention relates to an electronic circuit package in which a plurality of integrated circuit logic chips are mounted on an insulating substrate having an interconnection network selectively interconnecting input and output terminals of the chips with each other and with the terminals of the substrate, and to a method of testing such a package.

With the ever-increasing microminiaturization of integrated circuit chips, the testing of networks of electrical interconnections between such chips on substrates carrying the chips by physically accessing test points on the chips and the substrate is becoming exceedingly difficult. At one time it was conventional practice to use test probes to simultaneously contact all of the test points in the interconnection network necessary to test the network for short-circuits or breaks in the interconnections. However, as a result of microminiaturization the number of test points required to test the interconnection network has risen to the point where simultaneous physical contact with all of the test points has become impractical.

In U.S. patent 3,803,483 we describe testing the conductive interconnection network prior to the mounting of the integrated circuit chips on the substrate. In this testing scheme semiconductor test chips are temporarily mounted on each of the sites in the module where integrated circuit chips are to be subsequently mounted. Each of the test chips has a number of diodes, each connecting a different terminal of the test chip to a common terminal. The chip sites are each surrounded by a set of contact points in the interconnection network. When the test chips are in place a probe head applies selected potential levels to each set of contact points one chip point at a time. Voltages are then measured at the common terminal of test chips at other chip sites of the interconnection network to test for short-circuits and breaks in the network.

While this method was satisfactory it did not check the interconnection networks with the actual integrated circuit chips in place and it required the soldering and unsoldering of the test chips. We previously suggested incorporating masking circuitry on the actual circuit chips which could be selectively activated to prevent the outputs of the logic circuits on certain circuit chips from being transmitted out into the interconnection network while another circuit chip on the substrate is being tested. However even with the masking circuits, it was extremely difficult to check the interconnection network for continuity once the actual circuit chips were in place because, as pointed out previously, simultaneously probing the chips themselves is impractical.

In accordance with the present invention, there is provided an electronic circuit package in which a plurality of integrated circuit logic chips are mounted on an insulating substrate having an interconnection network selectively interconnecting input and output terminals of the chips with each other and with the terminals of the substrate, and in which each chip comprises a respective masking circuit associated with each output terminal which masking circuit, when activated, temporarily prevents a logic signal from reaching the respective output terminal, characterised in that each chip (20) includes semiconductor device means (40) logically connecting each input terminal (16) to a common output terminal (23) of the chip (20) and means 16a, 36 for activating all the masking circuits (29) of the chip simultaneously.

The invention further provides a method of testing such package comprising activating the masking circuits of all but one of the chips on the substrate, applying test signals to the input terminals of the said one chip, and measuring the potentials at the common terminals of the other chips.

An embodiment of the invention will now be described with reference to the accompanying drawings, wherein:-

Fig. 1 is a diagrammatic fragmentary plan view of a circuit package according to the present invention,

Fig. 2 is an enlarged diagrammatic fragmentary view of the upper left hand chip of figure 1,

Fig. 3 is a cross-section taken along line 3-3 of Fig. 2, and

Fig. 4 is a schematic view of the circuitry in a typical chip of Fig. 1.

4

## PREFERRED EMBODIMENT

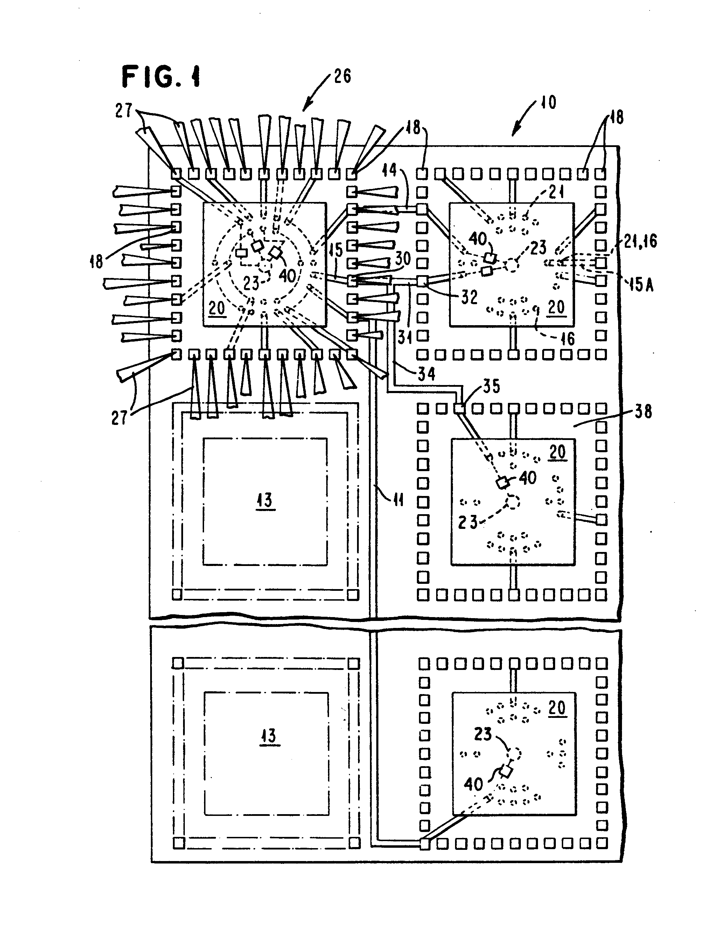

As shown in Figs. 1, 2 and 3, a circuit module comprises an insulating substrate 10, having an interconnection network 11 thereon which interconnects a plurality of integrated circuit chips 20 mounted at respective chip sites on the surface of substrate 10. For convenience in describing the embodiment of the invention, only a few representative chip sites 13 and representative portions of the interconnection network 11 are shown.

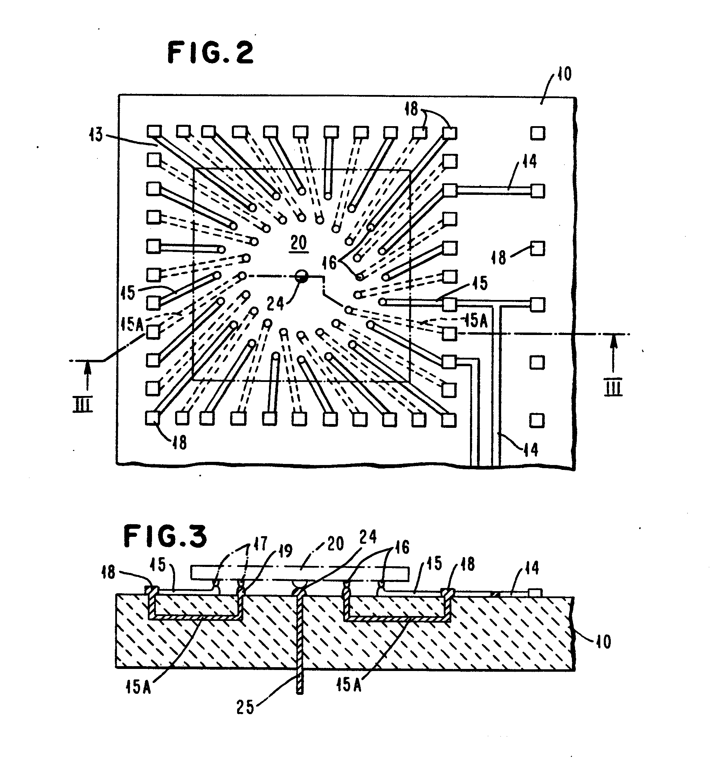

The interconnection network comprises inter-chip site connectors 14, as well as intra-chip connectors 15. Furthermore, the interconnection network may have portions, such as connectors 14 and 15 (Figs. 2 and 3), formed on the surface of substrate 10, as well as portions, such as intra-chip connectors 15A, which are formed below the surface level of substrate 10.

Substrate 10 may be conveniently made of a ceramic material, and in order to provide portions of the interconnection network, such as 15A, below the surface, a multi-level ceramic substrate may be used. Intra-chip connectors 15 and 15A connect to interconnection network terminals 19 corresponding to chip terminals 16 and 17 and these chip terminals are mounted upon and bonded to the interconnection terminals when the integrated circuit chip is mounted on substrate 10. Intra-chip connectors 15 and 15A respectively connect network terminals 19 to an array of pads 18 which are arranged in groups around the periphery of each chip site and are utilized as test points in the subsequent testing of the interconnection network by contacting such test points or pads 18 with a plurality of probes. Inter-chip connectors 14 respectively connect pads 18 associated with one chip site with pads associated with another chip site to form the interconnections between chip sites. The interconnection network 11 also connects the chips to substrate pins (not shown) by which the module is accessed externally.

For convenience of illustration, approximately forty network terminals 19 are shown as being associated with each chip site and, consequently, the chips to be mounted at the site will have forty corresponding terminals; also, forty test points or pads 18 are associated with each chip site. However, the state of the integrated circuit art is such that realistically there would be many more chip terminals and, consequently, more pads 18 per chip site.

The chips 20 are mounted at each of the chip sites by a "controlled-collapse" technique in which the chip terminals or pads are fused during joining. This "controlled-collapse" technique is described in detail in U.S. Patent No. 3,429,040 and in the article "A Critique of Chip Joining Techniques", L. F. Miller, Solid State Technology, April 1970, pp. 50 - 62. It should be understood, of course, that the integrated circuit chips could be joined to the substrate by other techniques such as beam lead, ultra-sonic bonding or thermocompressing bonding which are also described in the above publication.

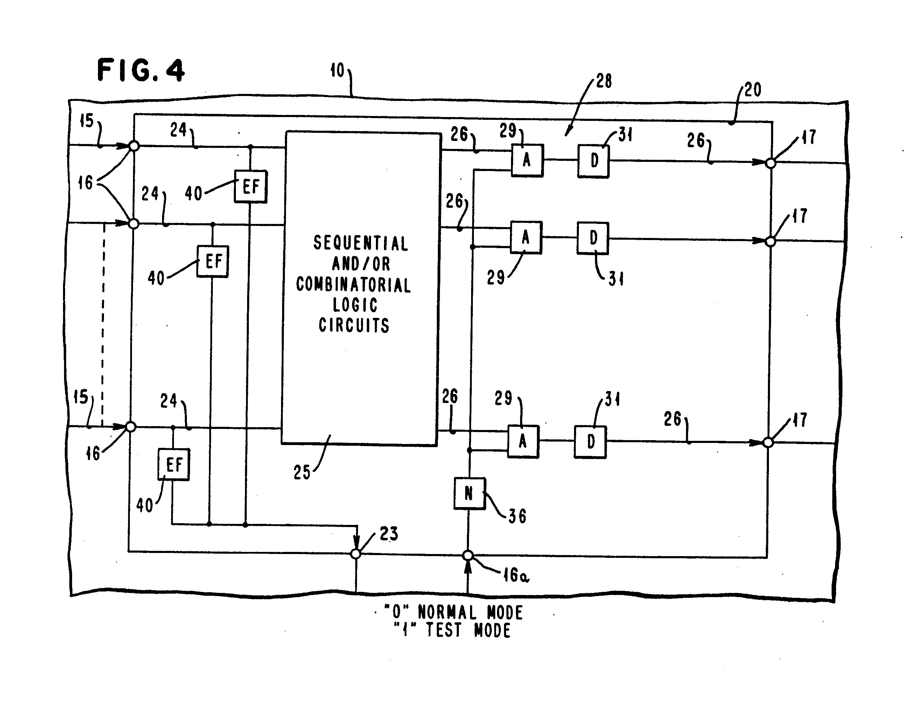

As shown in Fig. 4, each of the chips 20 mounted on the substrate 10 contain a plurality of both input terminals 16 and output terminals 17. These terminals are connected by conductors such as 14 and 15 on the
substrate 10 to input and output terminals of other
chips on the substrate and to input and output pins of
the substrate.

Each chip includes combinatorial and/or sequential
logic circuits 25 which are connected to the input
terminals 16 by input lines 24 and to the output terminals
17 by output lines 26. Each chip 20 also has masking
circuits 28 of the type described in the introductory
portion of this specification for preventing (during
testing) the response of the logic circuits 25 from
being passed to the output terminals 17 and thus from
being sent out onto the lines of the interconnection
network of the module. These masking circuits are used
in testing the chips 20 after mounting of the chips on
the substrate 10. The masking circuits typically
include AND gates 29 positioned between the output
lines 26 of the logic circuits 25 and the drivers 31
for the output terminals 17 of the chip. Besides
receiving a logic signal from the logic circuits 25,
each of these AND gates 29 receives a test control
signal which comes to the chip on an input terminal 16a
and is inverted in inverter 36 and fed into the AND
gates. When this signal is a binary "0" it permits
output signals from the sequential and combinatorial
logic circuits 25 to pass through to the drivers 31 and
out onto the lines 14 and 15 of the module in normal
manner. However, during test mode a binary "1" is
applied to all but the chip being tested. This places
a binary 0 at the inputs of the AND gates blocking the
transmission of information from the logic circuits 25
to the drivers 31. The drivers 31 therefore are in
their high impedance state and do not therefore transmit
signals out onto the lines of the interconnection
network of the module.

In accordance with the present embodiment, additional
circuits are added to each chip. These circuits are
emitter follower circuits 40. In addition to being
connected to the logic circuits 25 the input terminals
16 of each chip on the substrate are connected each to
the input of a respective emitter follower circuit 40
in the chip, and the outputs of all the emitter follower
circuits of the chip are logically ORed together and
taken off the chip at a common output terminal 23.

In the embodiment, emitter follower circuits 40
are used to transmit signals from the input terminals
16 of the chip to the common output terminal 23 on the
chip. This is technology dependent. Here the circuits
used in the logic are transistor transistor logic
circuits (TTL) and the emitter followers employed are
compatible with that circuitry. However it should be
understood that the emitter followers are not the only
means of transmitting signals from the inputs through
the chip. The most significant thing about these
circuits is that they isolate the terminals of the chip
from what is referred to as the common terminal and
from one another. Therefore the emitter followers
could be source followers if the technology were FET's
or if desired they could be diodes.

For convenience in illustration, common chip
terminal 23, corresponding substrate terminal 24, and
substrate pin 25 have been shown as being centrally
located at the chip sites, see fig. 3. This need not
be the case. The common terminal may be located at any
point on the chip provided that it is connected to a
point in the substrate which may be externally accessed,
either directly by a pin as shown, or indirectly by an

8

interconnector which runs along the insulating substrate 10 to a point which is externally accessed by a substrate pin. Since it is customary practice during the operation of the integrated circuit module to access points in the interconnection network with substrate pins which provide the various power supplies required, such power pins may be conveniently used temporarily during testing as pin 25 to provide external access to the common terminal in the chips.

Let us now consider a typical test cycle with reference to Fig. 1. A tester probe head 26 is shown contacting test points 18 at the first chip site. The structure of the test probe head is merely illustrative of standard tester probe heads known in the art. The head comprises an array of probes 27, one for each of the forty test points 18. A number of test probes 27 have been broken away so that the interconnection network 11 may be more readily seen. Head 26 is capable of moving in the X and Y directions. Each of the probes 27 is capable of applying selected voltages to test points 18 and capable of sensing voltage levels at these test points. The test probe head is controlled in a conventional manner by computer means, not shown, which has the capability of applying the voltages to the test points required by the testing procedure and for receiving and interpreting the data sensed by probes 27.

In a typical test procedure, a single test head 27 contacts the test points 18 associated with each of the chip sites in a pre-selected sequence. In Fig. 1, probe head 26 is shown in contact with the test points 18 associated with a first of the chip sites. Intra-chip connector 15 connected to point 30 comes from an output driver of the first chip being tested.

9

Next, a binary "1" is supplied to the input terminals 16a of all the chips 20 other than that undergoing test, and then a pre-selected set of test patterns is applied to the test points 18 of the first chip site via the probe head 26. The intent of the test pattern is to exercise the circuits 25 contained within the chip. During the application of the test patterns to the first chip site, common terminals 23 of the other chip sites are monitored. When point 30 goes to a logical 1 state, the common terminals 23 of the upper right-hand two chips should also go to a logical 1 state, demonstrating that interconnections 31 and 34 are not open. In a like manner, the common terminals 23 for all chip sites on the module are monitored during the application of the test pattern to the first chip site. Also, any substrate pins connected to the chip site being probed are monitored.

Upon the application of a complete set of test patterns at the first chip site, test head 26 is stepped to the next chip site to be tested and the procedure is repeated.

It should be noted that in the case shown in Figure 1, the chip in the upper right hand chip site is fed by more than one interconnection, 14 and 31, from the chip in the first chip site. Observations made at common terminal 33 will indicate a logical 1 if only one of the connections, 14 or 31, carry a logical 1 signal from the first chip site. It is very unlikely in actual practice that both interconnections 14 and 31 would simultaneously be at the logical 1 state throughout the entire sequence of test patterns. In any case, it is always possible to set a chip output to a logical 1 state using the test probes.

10

Accordingly, in the manner described, a single test head which is in contact with only a single chip site at any one time is used to test all aspects of the interconnection network on substrate 10 related to the chip site. This avoids simultaneous probing of more than one test site with more than one test head which becomes physically impractical because of increasing chip and test point densities.

1

CLAIMS

1.    An electronic circuit package in which a plurality
of integrated circuit logic chips are mounted on an
insulating substrate having an interconnection network
selectively interconnecting input and output terminals
of the chips with each other and with the terminals of
the substrate, and in which each chip comprises a
respective masking circuit associated with each output
terminal which masking circuit, when activated, temporarily prevents a logic signal from reaching the respective
output terminal, characterised in that each chip (20)
includes semiconductor device means (40) logically
connecting each input terminal (16) to a common output
terminal (23) of the chip (20) and means 16a, 36 for
activating all the masking circuits (29) of the chip
simultaneously.

2.    An electronic circuit package as claimed in claim
1, wherein the semiconductor device means are emitter
follower circuits.

3.    A method of testing a package as claimed in claim
1 or 2, comprising activating the masking circuits of
all but one of the chips on the substrate, applying
test signals to the input terminals of the said one
chip, and measuring the potentials at the common terminals
of the other chips.

# FIG. 1

# FIG.2

# FIG.3

FIG. 4

SEQUENTIAL AND/OR COMBINATORIAL LOGIC CIRCUITS

"0" NORMAL MODE
"1" TEST MODE

European Patent Office

| | DOCUMENTS CONSIDERED TO BE RELEVANT | | CLASSIFICATION OF THE APPLICATION (Int. Cl.²) |
|---|---|---|---|
| Category | Citation of document with indication, where appropriate, of relevant passages | Relevant to claim | |
| | ELEKTRO/CONFERENCE RECORD, no. 32/3, 1977, New York, P.BOTTORFF et al. "Impact of LSI on complex digital circuit board testing" pages 1 to 12 * pages 1, 9; fig. 10 * | 1,3 | G 01 R 31/28 G 01 R 31/02 |
| A | US - A - 3 746 973 (M.T. McMAHON JR.) * column 1, line 49 to column 2, line 38; column 5, line 3 to column 6, line 27; fig. 6 * | 1,3 | **TECHNICAL FIELDS SEARCHED (Int.Cl.²)** |
| A | DE - C3 - 2 003 060 (HITACHI) * claim; column 3, line 62 to column 4, line 52; fig. 1a * | 3 | G 01 R 31/02 G 01 R 31/28 H 01 L 21/66 |
| A | US - A - 3 795 973 (D.F. CALHOUN) * column 1, line 9 to column 2, line 9 * | | |
| A | US - A - 3 762 037 (TH. H. BAKER et al.) * column 1, line 8 to column 3, line 15 * | | **CATEGORY OF CITED DOCUMENTS** |
| A | GB - A - 1 3778 859 (I. CATT) * page 1 * | | X: particularly relevant A: technological background O: non-written disclosure P: intermediate document T: theory or principle underlying the invention E: conflicting application D: document cited in the application L: citation for other reasons |
| | | | &: member of the same patent family, corresponding document |

| X | The present search report has been drawn up for all claims | | |
|---|---|---|---|
| Place of search Berlin | Date of completion of the search 06-11-1979 | Examiner LEMMERICH | |

EPO Form 1503.1 06.78